Europäisches Patentamt

European Patent Office

Office européen des brevets

(11) Veröffentlichungsnummer: **0 284 882**
**A2**

## (12) EUROPÄISCHE PATENTANMELDUNG

(21) Anmeldenummer: 88104118.0

(22) Anmeldetag: 15.03.88

(51) Int. Cl.⁴: **H05K 7/18**

(30) Priorität: 31.03.87 DE 8704730 U
23.10.87 DE 8714184 U

(43) Veröffentlichungstag der Anmeldung:
**05.10.88 Patentblatt 88/40**

(84) Benannte Vertragsstaaten:
**DE FR GB IT NL SE**

(71) Anmelder: **Siemens Aktiengesellschaft Berlin
und München
Wittelsbacherplatz 2
D-8000 München 2(DE)**

(72) Erfinder: **Dörflinger, Karl, Dipl.-Ing. (FH)
Mühlthaler Strasse 103
D-8000 München 71(DE)**
Erfinder: **Höflmaier, Ernst
Franz-Senn-Strasse 17
D-8000 München 2(DE)**
Erfinder: **Prechtl, Wolfgang
Enzianweg 11
D-8192 Geretsried 1(DE)**
Erfinder: **Weis, Günther, Dipl.-Ing. (FH)
Frasdorfer Strasse 6 A
D-8000 München 90(DE)**

(54) **Einsatz für Gestelle der elektrischen Nachrichtentechnik.**

(57) In Gestellen der Nachrichtentechnik werden einschiebbare Geräteeinsätze benötigt. Die Erfindung soll einen einfachen Gehäuseaufbau hierfür angeben. Dies wird dadurch erreicht, daß der Einsatz aus miteinander verschnappbaren und verschraubbaren Blechteilen (1, 2, 8, 12) besteht, bei denen zur besseren elektrischen Kontaktierung zwischen den Blechen nockenförmige Ausprägungen (z.B. 25) vorgesehen werden.

FIG 1

## Einsatz für Gestelle der elektrischen Nachrichtentechnik.

Die Erfindung bezieht sich auf einen Einsatz für Gestelle der elektrischen Nachrichtentechnik, in dem sich durch seitliche Führungen gehaltene steckbare Leiterplatten befinden und bei dem das Gestell im wesentlichen durch spiegelbildlich zueinander angeordnete L-förmige Profile gebildet wird.

In der Nachrichtentechnik werden bei der sogenannten Bauweise 7R derartige Gehäuse verwendet, deren Teile jedoch meist mittels Punktschweißung verbunden sind.

Der Erfindung liegt die Aufgabe zugrunde, die Konstruktion eines derartigen Geräteeinsatzes zu vereinfachen.

Bei einem Einsatz der eingangs genannten Art wird diese Aufgabe gemäß der Erfindung dadurch gelöst, daß der Einsatz aus folgenden Teilen besteht:

a) aus einem an sich bekannten Kopfteil mit Gleitschienen unterhalb dessen sich in einem gegenüber dem restlichen Gehäuse abgesetzten Teil das Anschlußfeld befindet, auf dessen Rückwand elektrische Anschlußstecker angeordnet sind,

b) aus zwei Seitenteilen, die in geräteinnenseitig angebrachten Sicken mit waagerechten Schlitzen zum Einknöpfen von Führungsschienen für steckbare Leiterplatten versehen sind und im Bereich des Anschlußfeldes abgesetzt und oben am Kopfteil verschraubt sind sowie rückseitig Abkantungen nach innen haben, an denen die Buchsenleisten für die Steckeinschübe befestigt sind,

c) aus einem Rückwandteil, das sich nach vorne waagerecht abgebogen auch über den nach oben offenen Schacht unterhalb des gestellseitigen Anschlußfeldes erstreckt und dort mittels rechteckiger Lochungen, in die entsprechenden Zapfen an den Seitenteilen eingreifen, befestigt ist, und das unten mit einer Abkröpfung am Bodenblech verschraubt ist und auf den beiden Längsseiten in vertikaler Richtung etwas nach vorne abgekantet ist zur Überdeckung eines Verdrahtungsraumes für die Anschlußstecker der Steckeinschübe,

d) aus einem Bodenteil, das im Bereich der Sicken der Seitenteile außenseitig nach oben abgekantete Zapfen und zwischen den Sicken innenseitig eine längliche Abkantung als Gegenhalt für die zwischen beiden Elementen eingesteckte Seitenwand hat sowie rückwandseitig eine Abkantung nach oben in deren Mittenbereich die Verschraubung für die Rückwand angeordnet ist.

Zweckmäßig werden zur Verbindung des Bodenteils mit den Seitenteilen im Bereich zwischen den Sicken der Seitenteile Lochungen vorgesehen, in die entsprechende Nocken, vorzugsweise Ausprägungen, der länglichen Abkantungen des Bodenbleches eingreifen.

Durch diesen Aufbau ist eine einfache Verbindbarkeit der einzelnen Teile garantiert, wobei die Kompatibilität zu den an sich bekannten geschweißten Gehäusen gegeben ist.

Nachstehend wird die Erfindung anhand eines in den Figuren dargestellten Ausführungsbeispiels näher erläutert.

Die Figur 1 zeigt den Aufbau des Gehäuses teilweise in Explosivdarstellung.

Die Figuren 2 und 3 zeigen Einzelheiten der Bodenbefestigung.

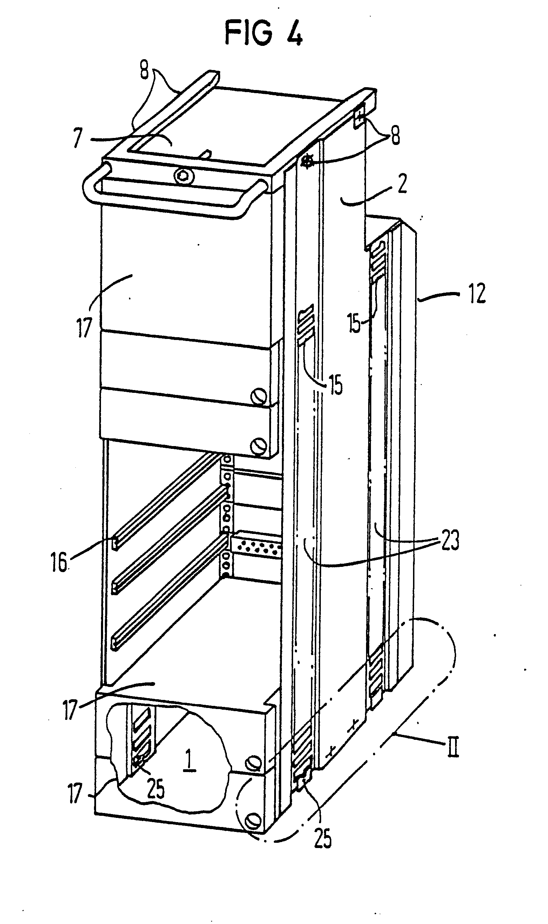

Die Figuren 4, 5, 6 und 7 zeigen Einzelheiten bezüglich der Massekontaktierung.

Im Prinzip besteht ein derartiges Gehäuse für einen Geräteeinsatz der Übertragungstechnik aus einem Kopfteil 7, zwei Seitenteilen 2, einem Bodenblech 1 und einer rückseitigen Abdeckung 12. Das Kopfteil ist als Alluminiumdruckgußteil ausgeführt und wie üblich mit einem vorderseitigen Griff versehen. Rückseitig ist es mit Führungsschienen 7a zum Einstecken in ein gestellseitiges Konsol ausgestattet. Im Raum unterhalb der Führungsschienen befindet sich ein Anschlußfeld mit frontseitigen Signalisierungs-und Bedienelementen und rückseitigen Steckanschlüssen 13 für Messerleisten sowie koaxiale und gegebenenfalls Lichtwellenleiterstecker. Die Seitenteile 2 sind mit vertikalen nach innen gewölbten Sicken 23 versehen, in denen sich rasterförmig waagerechte Schlitze 15 befinden. In diese Schlitze können, wie an sich bekannt, Führungsschienen 16 eingeknöpft werden und in die Führungsschienen sind steckbare Leiterplatten 17 einsteckbar. Diese haben - wie nicht sichtbar - rückwärtige Steckelemente, die in entsprechende Buchsenfelder eingreifen. Die Buchsenfelder sind an Abkantungen 18 der Seitenteile befestigt.

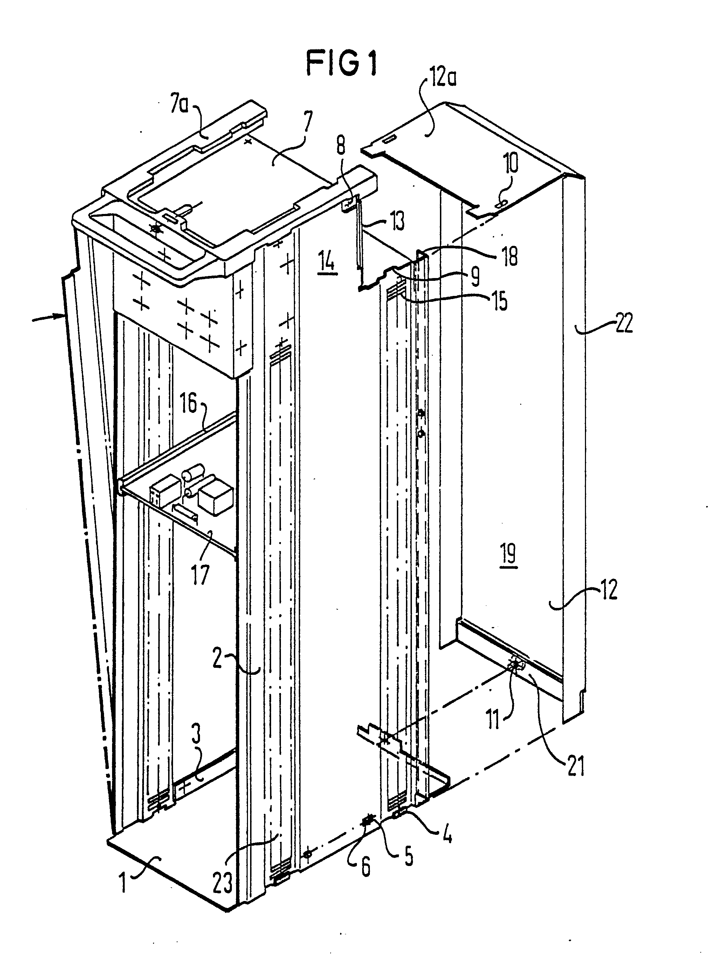

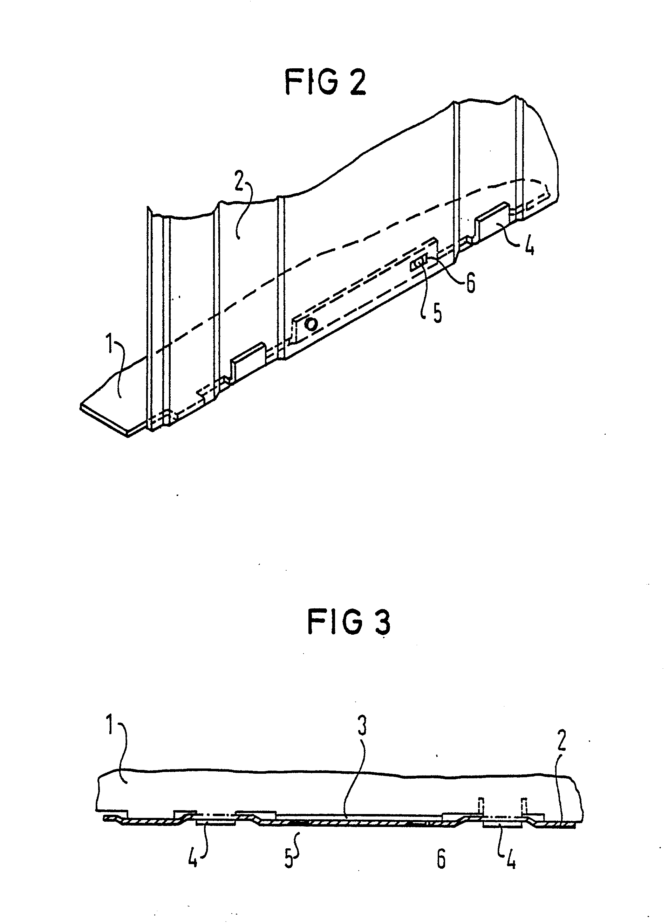

Mit dem Kopfteil sind die Seitenteile an den Stellen 8 verschraubt. Das Bodenteil 1 ist mit den Seitenteilen auf folgende Weise verbunden: Wie aus den Figuren 2 und 3 besser ersichtlich, hat das Bodenteil außenseitig nach oben abgekantete Zapfen 4 und innenseitig zwischen den Sicken eine längliche Abkantung 3. Zwischen diese Zapfen 4 und der Abkantung 3 sind die Seitenteile jeweils eingeteckt. Im Bereich des unteren Randes zwischen den Sicken der Seitenwände befinden sich in der Abkantung 3 Lochungen 6, von denen die eine aus Toleranzgründen als Langloch ausgebildet ist. In diese Lochungen können bei der Montage an den Seitenwänden befindliche genietete Zapfen oder Ausprägungen 5 eingreifen. Wie in der Figur 1 links angedeutet ist, können für die Befestigung vor dem Einrasten die Seitenteile schräg in das Bodenblech gesteckt werden und dann senkrecht aufgekippt werden.

Da insbesondere in diesem Bereich, zwischen Bodenblech und Seitenwänden Kontaktschwierigkeiten auftreten können, sind hier am untersten der zwischen den Schlitzen stehengebliebenen Stege 24 nockenförmige Ausprägungen 25 an beiden Seitenwänden angebracht. Das hat den Zweck beim Zusammenfügen der Seitenwände mit dem Bo denblech wenigstens an einer Stelle einen definierten Kontakt, der für Abschirmzwecke notwendig ist, herzustellen.

Es können auch an anderen entsprechenden Stellen des Gehäuses, das ja im wesentlichen aus gesteckten Blechen besteht, entsprechende Kontakthilfen vorgesehen werden.

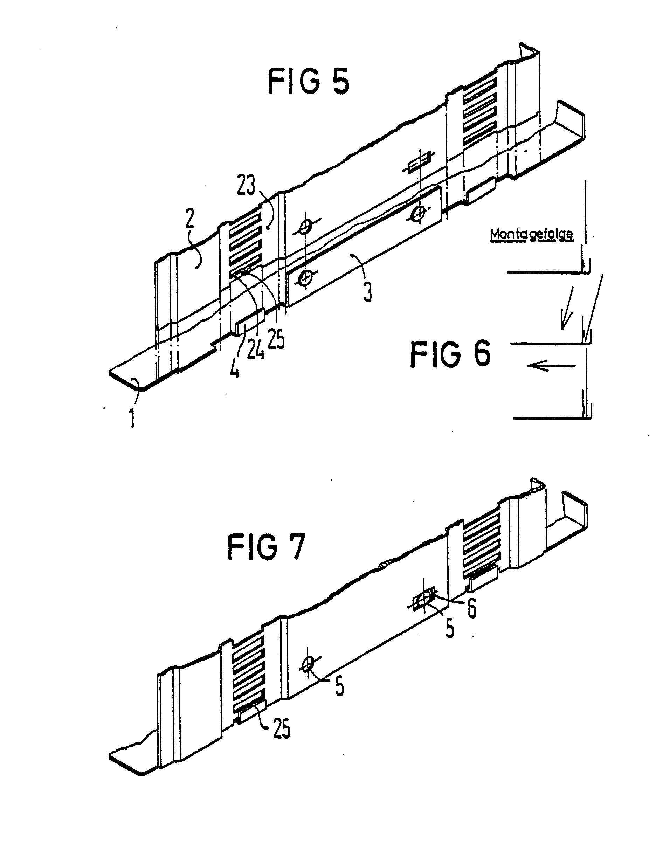

Für den hier gezeigten Fall ist jedoch schon aus Gründen leichterer Montage (siehe Figur 6) und weil weniger Andruckkraft erforderlich ist, sowie zur exakteren Definition, das heißt Lage des Kontaktpunktes, in jeder Seitenwand insbesondere im Bereich des vorderen Zapfens 4 nur eine Ausprägung am Steg 24 vorgesehen.

Rückseitig ist eine Abdeckkappe 12 vorgehen, die den abgesetzten Teil des Gehäuses unterhalb des Schaltfeldes 14 durch einen abgekanteten Teil 12a abdeckt. In diesem Bereich befinden sich an der Fortsetzung der hinteren Sicke mit den Schlitzen 15 Zapfen 9, die in entsprechende Ausnehmungen 10 am oberen Teil 12a eingreifen. Durch Kippen wird danach die Rückwand senkrecht gestellt und an ·der Stelle 11 ist eine Verschraubung mit dem Bodenblech vorgesehen, das zu diesem Zweck eine Abkantung 21 nach oben hat. Da die Anschlüsse der Steckerleisten für die Leiterplatten 17 nach hinten etwas hinausragen, ist ein Verdrahtungsraum 19 nötig, der durch seitlich abgebogene Lappen 22 der Rückwand abgedeckt wird.

Wegen der Verformbarkeit der Seitenteile sind die Schnappverbindungen auch bei größeren Fertigungstoleranzen herzustellen.

Durch die Anordnung (schraubbares Kopfteil) - nach Figur 1 - ist eine mehrmalige zerstörungsfreie Trennung der Verbindungteile möglich.

Das Verfahren bietet besondere Vorteile beim Verbinden von verzinkt, gelb chromatierten Blechen sowie für unterschiedliche Werkstoffkombinationen wie St/Alu, St/Ms usw. Die Montage der Einzelteile erfolgt an einem Arbeitsplatz ohne Werkstattwechsel wie bei der Schweißausführung. Zur Güteüberwachung ist eine einfache Sichtprüfung ausreichend.

Weitere Vorteile sind Reduzierung der Durchlaufzeit und Minderung des Lagerraumes. Die Fügetechnik Steck-Schraubtechnik - ist energiesparend. Das Gehäuse ist leicht demontierbar und falls erforderlich für den Versand in eine Verpackung ummontiert, woraus geringes Volumen und insgesamt geringere Herstellkosten resultieren.

## Ansprüche

1. Einsatz für Gestelle der elektrischen Nachrichtentechnik, in dem sich durch seitliche Führungen gehaltene steckbare Leiterplatten befinden und bei dem das Gestell im wesentlichen durch spiegelbildlich zueinander angeordnete L-förmige Profile gebildet wird, **dadurch gekennzeichnet,** daß der Einsatz aus folgenden Teilen besteht:

a) aus einem an sich bekannten Kopfteil (7) mit Gleitschienen (7a) unterhalb dessen sich in einem gegenüber dem restlichen Gehäuse abgesetzten Teil (14) das Anschlußfeld befindet, auf dessen Rückwand (13) elektrische Anschlußstecker angeordnet sind,

b) aus zwei Seitenteilen (2), die in geräteinnenseitig angebrachten Sicken (23) mit waagerechten Schlitzen (15) zum Einknöpfen von Führungsschienen (16) für steckbare Leiterplatten (17) versehen sind und im Bereich des Anschlußfeldes (14) abgesetzt und oben am Kofpteil verschraubt (8) sind sowie rückseitig Abkantungen (18) nach innen haben, an denen die Buchsenleisten für die Steckeinschübe (16) befestigt sind,

c) aus einem Rückwandteil (12), das sich nach vorne waagerecht abgebogen (12a) auch über den nach oben offenen Schacht unterhalb des gestellseitigen Anschlußfeldes erstreckt und dort mittels rechteckiger Lochungen (10), in die entsprechenden Zapfen (9) an den Seitenteilen (2) eingreifen, befestigt ist, und das unten mit einer Abkröpfung am Bodenblech (1) verschraubt (11) ist und auf den beiden Längsseiten in vertikaler Richtung etwas nach vorne abgekantet (22) ist zur Überdeckung eines Verdrahtungsraumes (19) für die Anschlußstekker der Steckeinschübe,

d) aus einem Bodenteil (1), das im Bereich der Sicken der Seitenteile außenseitig nach oben abgekantete Zapfen (4) und zwischen den Sicken innenseitig eine längliche Abkantung (3) als Gegenhalt für die zwischen beiden Elementen eingesteckte Seitenwand hat sowie rückwandseitig eine Abkantung (21) nach oben in deren Mittenbereich die Verschraubung (11) für die Rückwand angeordnet ist.

2. Einsatz nach Anspruch 1, **dadurch gekennzeichnet,** daß zur Verbindung des Bodenteils (1) mit den Seitenteilen (2) im Bereich zwischen den Sicken (23) der Seitenteile genietete Zapfen, vorzugsweise Ausprägungen (5) vorgesehen sind, die in entsprechende Lochungen (6) in den länglichen Abkantungen des Bodenbleches eingreifen.

3. Einsatz nach einem der vorhergehenden Ansprüche,
**dadurch gekennzeichnet,**
daß im Berührungsbereich der einzelnen gesteckten Bleche an einem der Blechteile nockenförmige Ausprägungen (25) zur Kontaktverbesserung angebracht sind.

4. Einsatz nach Anspruch 3,
**dadurch gekennzeichnet,**
daß die nockenförmigen Ausprägungen (25) am untersten der zwischen den Schlitzen (15) verbleibenden Stege (24) im Berührungsbereich mit den nach oben abgekanteten Zapfen (4) des Bodenbleches (1) vorgesehen sind.

5. Einsatz nach Anspruch 4,
**dadurch gekennzeichnet,**
daß die Ausprägungen jeweils nur im Bereich einer, insbesondere jeweils der vorderen Abkantung (4) vorgesehen sind.

# FIG 1

# FIG 2

# FIG 3

# FIG 4

# FIG 5

23

2

3

25

24

4

1

Montagefolge

# FIG 6

# FIG 7

6

5

5

25